# EUROPEAN PATENT SPECIFICATION

(11) **EP 4 230 946 B1**
(45) Date of publication and mention of the grant of the patent: **22.01.2025**
(21) Application number: 22157838.8
(22) Date of filing: 21.02.2022
(51) Int. Cl.: F28D 15/04, F28D 15/02

(54) **OSCILLATING HEAT PIPES**
OSZILLIERENDE WÄRMEROHRE
CALODUCS OSCILLANTS

(43) Date of publication of application: 23.08.2023
(73) Proprietor: Nokia Technologies Oy, 02610 Espoo (FI)
(72) Inventor: GRILLANDA, Stefano, New Jersey, 07974 (US); AMALFI, Raffaele Luca, New Jersey, 07974 (US); ENRIGHT, Ryan, New Jersey, 07974 (US)
(74) Representative: Swindell & Pearson Limited

(56) References cited:
- CN-A- 102 829 660
- CN-Y- 201 294 224
- US-A1- 2003 192 674
- US-A1- 2008 087 406
- VASILIEV ET AL: "Heat pipes in modern heat exchangers", APPLIED THERMAL ENGINEERING, PERGAMON, OXFORD, GB, vol. 25, no. 1, 1 January 2005 (2005-01-01), pages 1 - 19, XP027682034, ISSN: 1359-4311, [retrieved on 20050101]

## Description

### TECHNOLOGICAL FIELD

Examples of the disclosure relate to oscillating heat pipes. Some relate to oscillating heat pipes for cooling laser circuitry in LiDAR devices.

### BACKGROUND

Electronic components such as laser circuitry can generate unwanted heat during use. Cooling systems such as oscillating heat pipes can be used to transfer heat away from such components and improve their functioning.

Vasiliev et al.: "Heat pipes in modern heat exchangers", Appl. Therm. Engineering, Vol 25, No. 1, 2005 relates to a number of heat exchange methods. In particular a "spaghetti" heat pipe is disclosed. The "spaghetti" heat pipe consists of a large evaporator region and a compact condenser, with working ammonia fluid flowing between the regions. It operates due to the oscillating motion of the two phases of working fluid within, with the gaseous part of the fluid generated via evaporation within the evaporator and the liquid phase generated through condensation at the condenser region. The condenser is enveloped in a porous material and is in thermal contact with the evaporator region of an adsorption refrigerator.

US 2003/192674 relates to a heat transport device that can be used for cooling electronics equipment. It includes a container with a hollow structure in which a fluid channel is formed, a thermal-receiver-type heat exchanged and thermal-radiator-type heat exchanger arranged side by side on an outer wall of the container along the fluid channel, and driving heat exchangers provided at both terminal portions of the container. In this heat transport device, both ends of the fluid channel are closed to prevent intrusion of external air, and a liquid and gas are sealed in the fluid channel. The driving heat exchangers cause the liquid to oscillate in the container along its fluid channel. A porous element may be provided at the terminal portions of the container where the driving heat exchangers are provided.

US 2008/087406 discloses a planar pulsating heat pipe which may have a wick structure located within the evaporator tubing region. The evaporator region is in the middle, adjacent to a heat source, and the condenser regions are on either side where the u-shaped bends are located. Working liquid in two phases pulsates around the device in a closed loop, driven by alternating boiling and condensing which transports heat away from the evaporator regions.

CN201294224 discloses an open-cell foam metal heat pipe-fin combined CPU radiator. It consists of a heat source, base, open-cell foam metal, an air collecting chamber, hollow needle pins and a heat sink. Liquid is injected into the base cavity and evacuated into the foam metal, the bottom of the device is the hot evaporation end and the top of the device at the top of the hollow pin fins is the cool end. When the device is heated at the bottom end, evaporated water vapour flows into the hollow pins from the foam metal via the air collecting chamber. The vapour condenses back into water droplets on the walls of the pin and flow below, circulating continuously. Thus, heat is transferred away from the evaporator region.

### BRIEF SUMMARY

According to the invention, there is provided an oscillating heat pipe comprising:
a channel configured to enable flow of working fluid between at least one condenser region and at least one evaporator region;
at least one wick structure in fluidic connection with the channel so as to enable working fluid to flow from the channel into the wick structure; and
at least one vent configured to enable working fluid in an, at least partial, vapour phase to be returned from the wick structure to the channel.

The wick structure may be located within at least one evaporator region.

The oscillating heat pipe may comprise a plurality of U-shaped bends within the evaporator region.

The at least one wick structure may be located at, at least one of, the U-shaped bends.

A single wick structure may be fluidically connected to a plurality of different sections of evaporator regions of the oscillating heat pipe.

A plurality of wick structures may be connected to a plurality of different evaporator regions of the oscillating heat pipe.

The wick structure may comprise a gating portion and an evaporator portion.

According to various, but not necessarily all, examples of the disclosure there may be provided an apparatus comprising an oscillating heat pipe as claimed in any preceding claim and one or more heat sources wherein the oscillating heat pipe is configured to cool the one or more heat sources.

The one or more heat sources may comprise laser circuitry configured to enable light detection and ranging and wherein the oscillating heat pipe is configured to cool the laser circuitry.

The laser circuitry may be configured for light detection and ranging is configured to provide light in at least two distinct bands of wavelengths.

The laser circuitry may comprise at least two different reflective semiconductor optical amplifiers configured to provide light in, at least two distinct bands of wavelengths.

According to various, but not necessarily all, examples of the disclosure there may be provided an electronic device comprising an apparatus as described herein wherein the electronic device comprises at least one of; a communication device, a camera, a vehicle, and a part of a vehicle.

### BRIEF DESCRIPTION

Some examples will now be described with reference to the accompanying drawings in which:
FIG. 1 schematically shows an example oscillating heat pipe;
FIG. 2 schematically shows an oscillating heat pipe with wick structures;
FIG. 3 schematically shows a cross section of an oscillating heat pipe;
FIG. 4 schematically shows an example apparatus;
FIGS. 5A and 5B schematically shows an example laser circuity;
FIG. 6 shows example bands of wavelengths; and
FIGS. 7A and 7B show an example not according to the invention of how a working fluid can be added to a cooling system.

### DETAILED DESCRIPTION

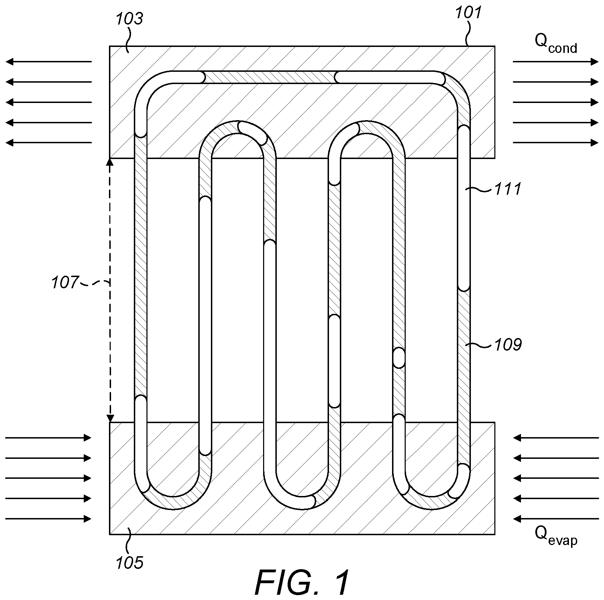

Fig. 1 schematically shows an example oscillating heat pipe 101. The oscillating heat pipe 101 comprises a condenser region 103, an evaporator region 105 and an adiabatic section 107.

The evaporator region 105 comprises any means for transferring heat from a heat source into the working fluid within the oscillating heat pipe 101. The evaporator region 105 is thermally coupled to a heat source. The heat source could be laser circuitry for a LiDAR device or any other suitable type of circuitry. The oscillating heat pipe 101 could be machined into the outer surfaces of components of the laser circuitry or other components.

The condenser region 103 comprises any means for transferring heat out of the working fluid within the oscillating heat pipe 101. The condenser region 103 can be thermally coupled to a heat sink or any other suitable type of means for transferring heat out of the working fluid.

The oscillating heat pipe 101 is configured in a meandering or serpentine configuration comprising a plurality of bends. A first plurality of bends is located in the evaporator region 105 and a second plurality of bends is located in the condenser region 103. In the example shown in Fig. 1 three U-shaped bends are shown in the evaporator region 105 and two U-shaped bends are shown in the condenser region 103. Other configurations and numbers of bends could be used in other examples of the disclosure. The meandering or serpentine configuration is configured so that the working fluid within the oscillating heat pipe 101 is alternately heated in the evaporator region 105 and cooled in the condenser region 103 of the oscillating heat pipe 101.

In the example shown in Fig. 1 an adiabatic section 107 is provided between the evaporator region 105 and the condenser region 103. The adiabatic section 107 extends between the bends in the condenser region 103 and the bends in the evaporator region 105. The adiabatic section 107 ensures that heat that is transferred into the working fluid in the evaporator region 105 is retained within the oscillating heat pipe 101 until the working fluid reaches the condenser region 103. In some examples the oscillating heat pipe 101 does not comprise an adiabatic section 107. Whether or not the oscillating heat pipe 101 comprises an adiabatic section 107 can depend on the application and system geometry of the oscillating heat pipe 101 and any other suitable factors.

When the oscillating heat pipe 101 is in use, heat is applied to the working fluid in the bends within the evaporator region 105. This heat causes, at least some of, the working fluid to evaporate. This evaporation results in an increase of vapour pressure inside the oscillating heat pipe 101 which causes the growth of bubbles 111 within the evaporator region 105. The growth of the bubbles 111 and the increase in vapour pressure forces liquid slugs 109 of the working fluid towards the condenser region 103. The working fluid that is pushed to the condenser region 103 is then cooled by the condenser. This cooling reduces the vapour pressure within the working fluid and causes condensation of the bubbles 111 and provides a restoring force that pushes the working fluid back towards the evaporator region 105. This process of alternate bubble growth and condensation causes oscillation of the working fluid within the oscillating heat pipe 101 and allows for the transfer of heat between the evaporator region 105 and the condenser region 103.

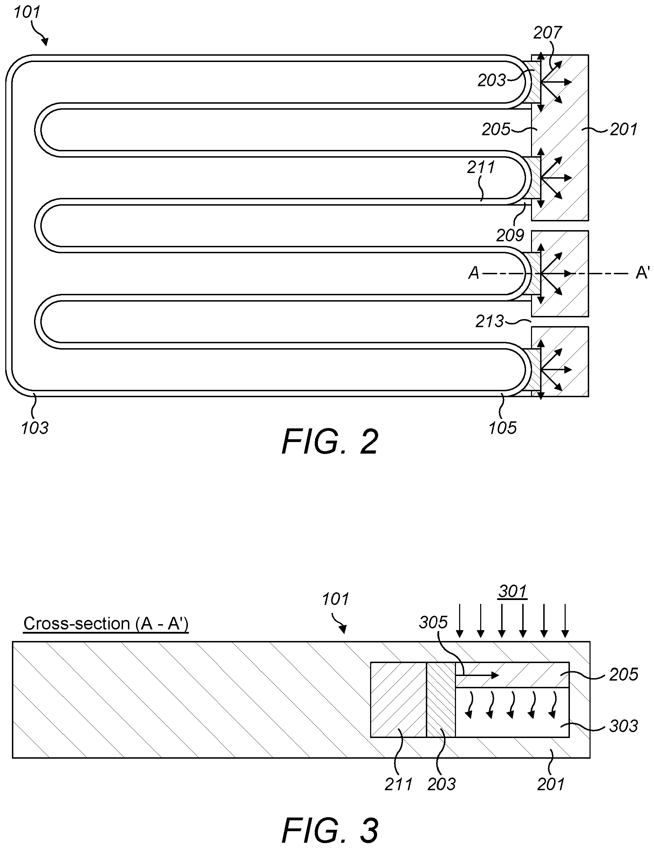

Fig. 2 schematically shows an oscillating heat pipe 101 with wick structures 201. The addition of the wick structures 201 increases the efficiency with which the oscillating heat pipe 101 can transfer heat. This can enable the oscillating heat pipe 101 of Fig. 2 to be used to cool components that generate large amounts of unwanted heat. For example, the oscillating heat pipe 101 could be used to cool laser circuitry for a LiDAR devices or any other suitable type of circuitry or electronic components.

The oscillating heat pipe 101 comprises a channel 211 that is configured to enable flow of working fluid between at least one condenser region 103 and at least one evaporator region 105. In the example of Fig. 2 one condenser region 103 and one evaporator region 105 are shown. In other examples the oscillating heat pipe 101 could comprise a plurality of condenser regions 103 and/or a plurality of evaporator regions 105. The number of condenser regions 103 and evaporator regions 105 could be determined by the number and locations of heat sources that are to be cooled by the oscillating heat pipe 101, the number and locations of heat sinks that enable heat to be transferred from the condenser regions 103 and/or any other suitable factor.

The oscillating heat pipe 101 comprises a plurality of bends in the evaporator region 105. The bends allow the channel 211 of the oscillating heat pipe 101 to extend in different directions. In this example they enable the channel 211 to double back on itself so that different sections of the channel 211 extend in opposing directions. The sections that extend in opposing directions can be parallel, or substantially parallel. In the example of Fig. 2 the plurality of bends are U-shaped, or substantially U-shaped. In the example of Fig. 2 the oscillating heat pipe 101 comprises four U-shaped bends in the evaporator region. The oscillating heat pipe 101 could comprise a different number of U-shaped bends in other examples of the disclosure.

In the example of Fig. 2 the oscillating heat pipe 101 comprises a wick structure 201. The wick structure 201 is located external to the channel 211 of the oscillating heat pipe 101. In the example of Fig. 2 the wick structure 201 is located within the evaporator region 105. In examples where the oscillating heat pipe 101 comprises a plurality of evaporator regions the wick structure 201 could be provided in all of the evaporator regions 105 or could be provided in just a subset of the evaporator regions 105. In other examples the wick structure 201 could be located in a different position of the oscillating heat pipe 101.

The wick structure 201 can be provided adjacent to the bends in the evaporator region 105. In the example of Fig. 2 the wick structure 201 is located at the U-shaped bends. In the example of Fig. 2 the wick structure 201 is located on each of the U-shaped bends. In other examples the wick structure 201 could be provided on just a subset of the U-shaped bends.

The wick structure 201 can be formed from any suitable material. In some examples the wick structure 201 can be formed from a thermally conductive material such as copper or silicon to enable efficient transfer of heat into the wick structure 201. In some examples different portions of the wick structure 201 can be formed from different materials, such as glass or ceramic.

The wick structure 201 comprises microfluidic channels. Working fluid from the oscillating heat pipe 101 can flow through the microfluidic channels of the wick structure 201 by capillary action. This can provide for a higher fluidic resistance compared to the channel 211 of the oscillating heat pipe 101, but also enable lower thermal resistance.

The wick structure 201 is external to the channel 211 of the oscillating heat pipe 101 but is provided in fluidic connection with the channel 211 of the oscillating heat pipe 101. This fluidic connection enables working fluid from the channel 211 of the oscillating heat pipe 101 to flow from the channel 211 into the wick structure 201.

Different arrangements of the wick structure 201 can be used in different examples of the disclosure. In some examples a single wick structure 201 can be fluidically connected to a plurality of different sections of evaporator regions 105 of the oscillating heat pipe 101. For example, a single continuous wick structure 201 could be connected to a plurality of U-shaped bends, or other suitable sections, of the evaporator region 105. An example of this is shown in the top half of Fig. 2 where the wick structure 201 is continuous between two of the U-shaped bends of the oscillating heat pipe 101. In this arrangement the wick structure 201 is not thermally isolated for the different bends of the oscillating heat pipe 101.

In some examples different wick structures 201 can be fluidically connected to different sections of evaporator regions 105 of the oscillating heat pipe 101. For example, a plurality of separate wick structures 201 could be connected to a plurality of U-shaped bends, or other suitable sections, of the evaporator region 105. An example of this is shown in the lower half of Fig. 2 where the wick structure 201 is discontinuous between two of the U-shaped bends of the oscillating heat pipe 101. In this example the discontinuous wick structures 201 can be thermally isolated from the wick structures 201 on different bends of the oscillating heat pipe 101. In some examples an isolation wall 213 can be provided between the different wick structures 201. The isolation wall 213 can be configured to separate different sections of the wick structure 201. The isolation wall 213 can comprise any suitable thermally insulating material that can prevent the transfer of heat and/or working fluid between the different wick structures 201 on the different bends. In some examples the isolation wall 213 can also enable pressure distributions across the different wick structures 201 to be controlled.

In the example of Fig. 2 the wick structure 201 comprises a plurality of different portions. The different portions of the wick structure can be configured to enable different functions to be performed. In the example of Fig. 1 the wick structure 201 comprises a gating portion 203 and an evaporator portion 205. Both of these portions can be external to the channel of the oscillating heat pipe 101.

The gating portion 203 can cover a section of the outer surface of the channel 211 of the oscillating heat pipe 101.The gating portion 203 is configured to enable fluid to flow out of the channel 211 of the oscillating heat pipe 101 into the wick structure 201. The gating portion 203 can be configured to allow liquid to pass through preferentially to vapour. The gating portion 203 can enable working fluid to flow from the channel 211 of the oscillating heat pipe 101 through the gating portion 203 and into the evaporator portion 205. The flow of working fluid from the channel 211 of the oscillating heat pipe 101 through the gating portion 203 and into the evaporator portion 205 is indicated by the arrows 207 in Fig. 2.

The evaporator portion 205 of the wick structure 201 is configured to enable heat to be transferred to the working fluid in the wick structure 201. The evaporator portion 205 can be in good thermal contact with a heat source. The evaporator portion 205 can be configured to enable efficient heat transfer between the heat source and the working fluid in the evaporator portion 205. For example, the evaporator portion 205 could have a large surface area to facilitate the transfer of heat and/or the evaporation of the working fluid.

The oscillating heat pipe 101 also comprises at least one vent 209. The vent 209 is configured to enable working fluid in an, at least partial, vapour phase to be returned from the wick structure 201 to the channel 211 of the oscillating heat pipe 101.

The vent 209 extends from the wick structure 201 into the channel 211 of the oscillating heat pipe 101. The vent 209 is configured to enable evaporated, or partially evaporated, working fluid to flow from the wick structure 201 back into the channel 211 of the oscillating heat pipe 101.

The vents 209 can be located so as to bias the flow of working fluid within the channel 211 of the oscillating heat pipe 101.

In the example shown in Fig. 2 a vent 209 is provided on each bend of the evaporator region 105. Other arrangements for the vents 209 could be used in other examples. The arrangements used for the locations of the vents 209 may be determined by the locations of the wick structure 201, the geometry of the channel of the oscillating heat pipe 101 or any other suitable factor.

The vents 209 can be configured so that any working fluid that flows from the channel 211 into the wick structure 201 is returned to the channel 211 via the vent 209. This can maintain the mass of working fluid within the oscillating heat pipe 101. The return of the working fluid back into the channel 211 of the oscillating heat pipe 101 can enable the oscillating heat pipe 101 to function as a closed loop. In the closed loop the evaporated working fluid is returned to the oscillating heat pipe 101 rather than being lost to the environment.

Any suitable processes can be used to form the oscillating heat pipe 101 and the wick structure 201. In some examples the oscillating heat pipe 101 and/or the wick structure 201 can be machined into the walls and/or other surfaces of an electronic device that comprises the oscillating heat pipe 101. The oscillating heat pipe 101 and/or the wick structure 201 can be formed using dry etching, selective laser wet etching or any other suitable processes.

Fig. 3 schematically shows a cross section of the oscillating heat pipe 201 shown in Fig. 2. The cross section is taken through the line A-A' as shown in Fig. 2. Corresponding reference numerals are used for corresponding features.

The cross section shows the different portions 203, 205 of the wick structure 201. This shows the gating portion 203 and the evaporator portion 205 of the wick structure 201.

The gating portion 203 is provided adjacent to the channel 211 of the oscillating heat pipe 101. In this example there are no intervening components between the channel 211 of the oscillating heat pipe 101 and the gating portion 203 of the wick structure 201. The gating portion 203 can be configured to provide a part of the wall of the channel 211 of the oscillating heat pipe 101. The gating portion 203 is directly connected to the channel 211 so that the working fluid can flow from the channel 211 into the gating portion 203. The working fluid can flow from the channel 211 into the gating portion 203 by capillary action.

The gating portion 203 is provided between the channel 211 of the oscillating heat pipe 101 and the evaporator portion 205 of the wick structure 201 so that the evaporator portion 205 of the wick structure 201 is provided adjacent to the gating portion 203. In this example there are no intervening components between the gating portion 203 and the evaporator portion 205. The wick structure 201 is configured so that working fluid flows from the gating portion 203 into the evaporator portion 205 as indicated by the arrow 305 in Fig. 3.

In the example shown in Fig. 3 the evaporator portion 205 is arranged in a different orientation to the gating portion 203. The evaporator portion 205 is arranged in a perpendicular orientation, or substantially perpendicular orientation, to the gating portion 203. As shown in Fig. 3 the gating portion 203 extends in a largely vertical plane while the evaporator portion 205 extends in a largely horizontal plane. This arrangement of the evaporator portion 205 can provide for a larger surface area which can facilitate the transfer of heat and the evaporation of the working fluid.

In some examples the different portions of the wick structure 201 can be formed from different materials. The gating portion 203 mainly enables the transfer of fluid rather than the transfer of heat and so does not need to be as thermally conductive as the evaporator portion 205. As an example, the evaporator portion 205 could be formed from a thermally conductive material such as a metal so as to enable efficient transfer of heat through the evaporator portion 205 and the gating portion 203 could be formed from a different material such as glass.

A cavity 303 is positioned underneath the evaporator portion 205. The cavity 303 provides a space for evaporated working fluid. The cavity 303 can be fluidically connected to the vent 209 as shown in Fig. 2 so that evaporated working fluid, or partially evaporated working fluid, can flow from the cavity 303 into the vent 209 and be returned to the channel 211 of the oscillating heat pipe 101.

When the oscillating heat pipe 101 as show in Figs. 2 and 3 is in use heat 301 from a heat source is applied to the evaporator portion 205 of the wick structure 201. The heat source could be circuitry or electronic components that generate unwanted heat during use, or any other suitable heat sources. This causes the heating and evaporation of working fluid within the wick structure 201. As the working fluid evaporates more working fluid is drawn out of the channel 211 of the oscillating heat pipe 101 and into the wick structure 201.

The working fluid that has evaporated from the wick structure 201 enters the cavity 303. The evaporated, or partially evaporated, working fluid then returns to the channel 211 of the oscillating heat pipe 101 via the vent 209.

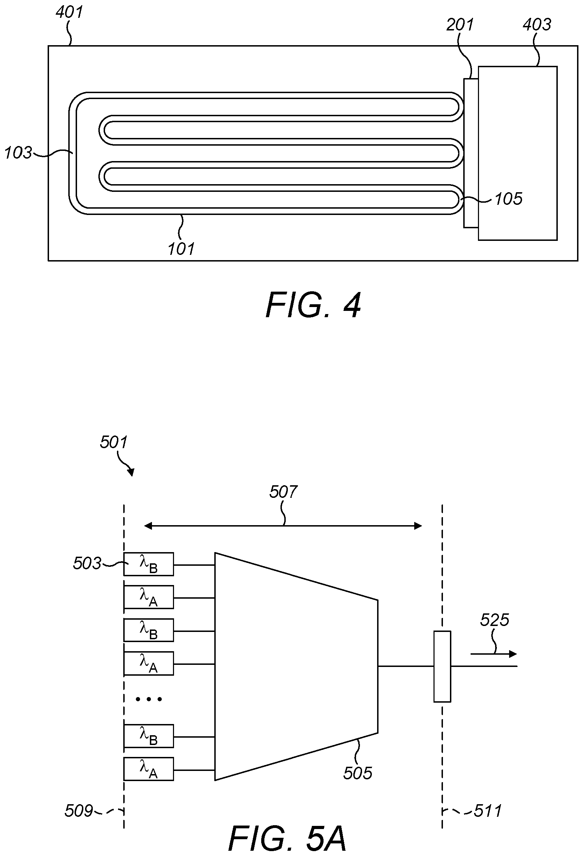

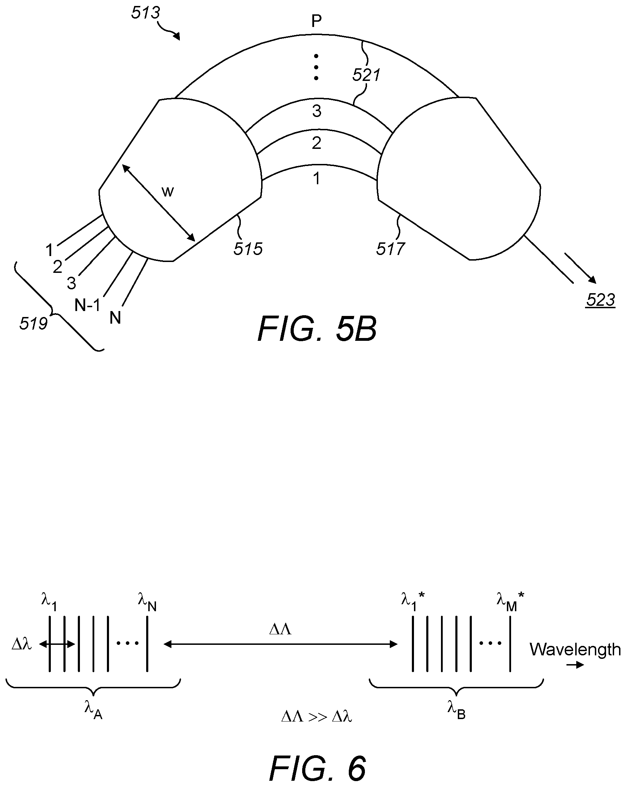

The use of the wick structure 201 therefore provides for efficient transfer of heat to the working fluid and can improve the efficiency of heat transfer by the oscillating heat pipe 101. This can make the oscillating heat pipe 101 suitable for use for colling components or circuitry that generate relatively large amounts of unwanted heat. For example, it could be used to cool laser circuitry as shown in Figs. 5 and 6 or any other suitable type of circuitry.

Variations to the structure and geometry of the oscillating heat pipe 101 and the wick structure 201 could be used in other examples of the disclosure. For instance, the wick structure 201 could be provided as s ingle portion rather than a gating portion 203 and an evaporator portion 205.

Fig. 4 schematically shows an example apparatus 401 comprising an oscillating heat pipe 101 and one or more heat sources 403. In the example of Fig. 4 only one heat source 403 is shown. It is to be appreciated that, in other examples of the disclosure, the apparatus 401 could comprise a plurality of heat sources. The apparatus 401 could be comprised within an electronic device such as a communication device, a camera, a vehicle, a part of a vehicle or any other suitable device.

The oscillating heat pipe 101 is configured within the apparatus 401 so as to cool the one or more heat sources 403. The oscillating heat pipe 101 can comprise an evaporator region 105 and a condenser region 103. The oscillating heat pipe 101 can comprise one or more wick structures 201. The one or more wick structures 201 can be as shown in Figs. 2 and 3 and/or can be provided in any other suitable arrangement or configuration.

In the example of Fig. 4 the wick structure 201 is provided in the evaporator region 105 of the oscillating heat pipe 101. In this example the wick structure 201 comprises a continuous structure that extends across a plurality of U-shaped bends of the channel 211 of the oscillating heat pipe 101. Other arrangements of the wick structure 201 could be used in other examples of the disclosure.

The wick structure 201 could comprise a gating portion 203 and an evaporation 205 as shown in Figs. 2 and 3 or could be provided in a single portion.

The components of the apparatus 401 are arranged so that the wick structure 201 of the oscillating heat pipe 101 are in thermal contact with the one or more heat sources 403. In examples where the wick structure 201 comprises a gating portion 203 and an evaporator portion 205 the evaporator portion 205 of the wick structure 201 can be in thermal contact with the one or more heat sources 403. This thermal contact can enable heat from the heat sources to be transferred to working fluid in the wick structures 201.

The heat sources 403 can comprise any components or circuitry that generate unwanted heat during use. In some examples the heat sources 403 can comprise laser circuitry configured to enable light detection and ranging (LiDAR). The LiDAR can be used to detect objects, obtain images of objects, determine positions of objects or for any other suitable purpose.

In the example shown in Fig. 4 the oscillating heat pipe 101 is configured to cool a single heat source 403. In this example the oscillating heat pipe 101 comprises a single condenser region 103 and a single evaporator region 105. In other examples the oscillating heat pipe 101 could comprise a plurality of condenser regions 103 and/or a plurality of evaporator regions 105. The oscillating heat pipe 101 can be configured so that different evaporator regions 105 can be used to cool different heat sources 403. In examples where the different heat sources 403 are provided in different locations with the device 401 the oscillating heat pipe 101 can be arranged so that the different evaporator regions 105 are also provided in different locations. Similarly, the condenser regions 103 can be provided in different locations to enable the device 401 to comprise a plurality of different heat sinks in different locations.

Figs. 5A and 5B schematically shows an example laser circuity 501 that could be one or more of the heat sources 503 in some examples of the disclosure. The laser circuitry can be configured for LiDAR applications or for any other suitable purpose. In this example the laser circuitry 501 is configured to provide light in at least two distinct bands of wavelengths. The two bands of wavelengths can be distinct in that the gap between the bands of wavelengths is much bigger than the gap between the wavelengths used within the bands of wavelengths.

The example laser circuitry 501 comprises an array 503 of gain sections and an optical wavelength multiplexer 505. The gain sections can comprise Reflective Semiconductor Amplifiers (RSOAs) or any other suitable types of moderators.

The array 503 of gain sections and the optical wavelength multiplexer 505 are provided within a laser cavity 507. A first reflective surface 509 is provided on a first side of the laser cavity 507 and a second reflective surface 511 is provided on a second side of the laser cavity 507. The array 503 of gain sections and the optical wavelength multiplexer 505 are provided between the reflective surfaces.

The array 503 of gain sections, when coupled to the optical wavelength multiplexer 505, are configured to provide a set of output light signals, each at a particular wavelength. A single output wavelength can be obtained from each of the gain sections when the light emitted by each of them is transmitted through the wavelength multiplexer 505.

In the example of Fig. 5A six of the gain sections in the array 503 are shown. It is to be appreciated that the array 503 could comprise any suitable number of gain sections. The array 503 could comprise many more than six gain sections.

The array 503 can comprise a plurality of different subsets of gain sections. The different subsets of the gain sections can be configured to provide light in different wavelength bands. In the example of Fig. 5A the array 503 comprises two subsets of gain sections. The first subset are configured with a gain spectrum in a first wavelength band λ_{A} and the second subset are configured with a gain spectrum in a second, different wavelength band λ_{B}.

The different subsets of the gain sections within the array 503 can be arranged in any suitable configuration. In the example of Fig. 5A the different subsets are provided in an alternating configuration. In this example the array 503 comprises an alternating sequence of a gain section that provides light in the first wavelength band λ_{A} followed by a gain section that provides light in the second wavelength band λ_{B}. Other arrangements for the array 503 of gain sections could be used in other examples. For instance, a first subset of the gain sections could be provided at a first side of the laser cavity 507 and a second subset could be provided a second side.

The gain sections can generate unwanted heat during use. The gain sections could therefore provide a heat source 403 that could be cooled using an oscillating heat pipe 101 as described herein.

The optical wavelength multiplexer 505 can be configured to combine the outputs of the individual gain sections within the array 503 to provide a single combined output. Any suitable means could be used as the optical wavelength multiplexer 505. In some examples the optical wavelength multiplexer 505 could be implemented using an arrayed waveguide grating. An example of an arrayed waveguide grating 513 that could be used is shown in Fig. 5B. Other suitable means could be used as the optical wavelength multiplexer 505, such as for example echelle gratings or circuits formed by an arrangement of microring resonators, Mach-Zehnder interferometers or Bragg gratings.

Fig. 5B schematically shows a top-view of an arrayed waveguide grating 513. The arrayed waveguide grating 513 comprises a first star coupler 515, a second star coupler 517, a plurality of input waveguides 519, a plurality of connecting waveguides 521, and an output waveguide 523.

The plurality of input waveguides 519 are coupled to the input of the first start coupler 515. In this example N input waveguides 519 are coupled to the input of the first star coupler 515. The number of input waveguides 519 can be the same as the number of gain sections in the array 503. An input waveguide 519 can be provided for each of the gain sections within the array 503.

The input waveguides 519 can be coupled to the gain sections so that the input waveguides receive light emitted by the gain sections. In this example each of the input waveguides 519 is coupled to a different gain section so each waveguide receives an input from a different gain section. Optical coupling between the gain sections and the input waveguides 519 can be achieved through direct butt-coupling between the gain sections chips and the chip hosting the wavelength multiplexer or by using free-space components, such as for example lenses. Alternatively, in some materials platforms, the gain sections and the wavelength multiplexers can be fabricated monolithically on the same chip, so that the output of each gain section is directly connected to each of the waveguides 519.

The first star coupler 515 can comprise any means that can be configured to distribute the input light to a plurality of outputs. In some examples the first star coupler 515 can be configured to uniformly distribute the input light to the plurality of outputs. The first star coupler 515 can be configured to function as a power splitter and splits power from each of the input waveguides 519 across the outputs of the star coupler 515.

In this example the first star coupler 515 comprises a waveguide that has a larger width compared to a standard waveguide. For example, the width w of the first star coupler 515 can be much larger than the width of the input waveguides 519. The width w of the first star coupler 515 can be large enough so that there is no lateral confinement of the light that is input to the first star coupler 515.

The arrayed waveguide grating 513 also comprises a plurality of connecting waveguides 521 connecting the first star coupler 515 to the second star coupler 517. In this example the arrayed waveguide grating 513 comprises P waveguides 521 connecting the first star coupler 515 to the second star coupler 517. The number of waveguides 521 that are used can be selected based on specifications of the laser circuitry 501 or any other suitable factors.

The connecting waveguides 521 have different lengths. The connecting waveguides 521 have different lengths so that the light that travels through the connecting waveguides 521 travels through different distances depended upon which connecting waveguide 521 is used. The different lengths of the connecting waveguides 521 introduce different phase shifts into the light that travels through the different connecting waveguides 521. Other means for introducing phase shifts into the light signals could be used in other examples of the disclosure.

The light that travels through the connecting waveguides 521 is input to the second star coupler 517. The second star coupler 517 can have a similar structure to the first star coupler 515. The second star coupler 517 also comprises a waveguide having a large width. The width of the second star coupler 517 can also be large enough so that there is no lateral confinement of the light in the second star coupler 517.

The second star coupler 517 is configured to combine the input P signals from the connecting waveguides 521 and provide a single output via the output waveguide 523. The single output comprises a combination of the plurality of input signals.

The arrayed waveguide grating 513 therefore provides the output 525 of the optical wavelength multiplexer 505 as shown in Fig. 5A. This output 525 is a single output that comprises light from each of the RSOAs in the array 503.

Fig. 6 shows example bands of wavelengths that can be generated by the laser circuitry 501 as shown in Figs. 5A and 5B.

The example wavelengths comprise a first wavelength band λ_{A} and a second wavelength band λ_{B}. The first wavelength band λ_{A} comprises a plurality of wavelengths λ₁ to λ_{N}. Each of the wavelengths is separated by a difference Δλ. Similarly, the second wavelength band λ_{B} comprises a plurality of wavelengths λ_{1*} to λ_{M*}. In an example, each of these wavelengths in the second band is also separated by a difference Δλ. The difference Δλ between the wavelengths can be different for the different wavelength bands λ_{A}, λ_{B.} A different separation between the wavelengths of the first wavelength band λ_{A} and of those of the second wavelength band λ_{B} can be achieved based on the configuration of gain sections.

The wavelength bands are distinct from each other. There is a difference ΔΛ between the two wavelength bands. The difference ΔΛ is much larger than the difference Δλ. This means that the gap between the two wavelength bands is much larger than the gaps between the wavelengths within the bands.

By way of non-limiting example, the difference ΔΛ between the two wavelength bands could be of the order of 200nm while the difference Δλ between the wavelengths within the bands could be of the order of one nanometer. As an example, the first wavelength band λ_{A} could be centered around 1300nm and the second wavelength band λ_{B} could be centered around 1550nm. The gaps between the wavelengths within the bands could be around 4.8nm. Other values for the wavelengths could be used in other examples of the disclosure.

The laser circuitry 501 that is configured to provide outputs in two different wavelength bands can be used to provide improved LiDAR systems. Having the outputs in the two different wavelength bands can enable the LiDAR system to be used to obtain information at different resolutions. For example, a higher resolution can be achieved with the outputs with the shorter wavelength while a lower resolution can be achieved with the outputs with the longer wavelengths. The different resolutions could be used to obtain different images and/or to detect or identify different objects. The laser circuitry 501 could be configured to enable a user to select which of the wavelength bands they want to use or whether to use both of the wavelength bands.

In examples of the disclosure an oscillating heat pipe 101 such as the oscillating heat pipe 101 shown in Figs. 2 and 3 could be used to cool the laser circuitry 501 or parts of the laser circuitry 501. The laser circuitry 501 could be formed on a glass substrate or any other suitable type of material such as silicon, indium phosphide, silicon nitride. The oscillating heat pipe 101 could be formed within the glass substrate to enable cooling of the laser circuitry 501. The glass substrate could be thermally insulating and so, to enable heat transfer, a plurality of thermally conducting vias could be provided within the substrate. The thermally conducting vias could be formed from metal or any other suitable thermally conducive materials. The thermally conducive vias can be positioned within the substrate so as to create areas of high thermal conductivity and areas of low thermal conductivity within the substrate. For instance, areas of high thermal conductivity could be created between the RSOAs or other heat sources and the evaporating portion 205 of the wick structure 201.

In some examples a heat transfer path can be provided different components of the laser circuitry 501. For example, a heat transfer path, defined by the OHP channels, could be provided between the RSOAs and the arrayed waveguide grating 513. This heat can be used to enable the output wavelengths to be adjusted during the operation of the laser circuitry 501.

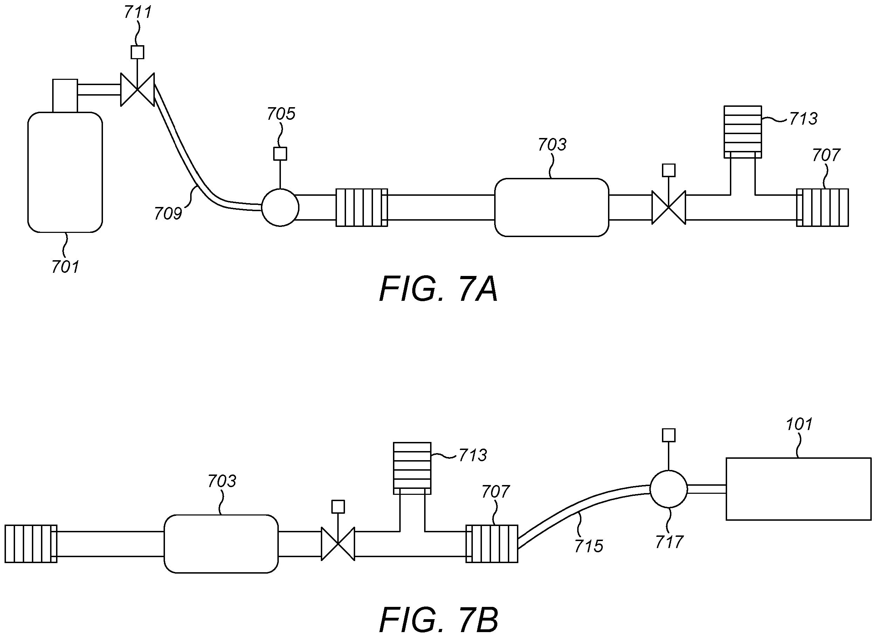

Figs. 7A and 7B show a system not according to the invention that can be used to enable working fluid can be added to a cooling system. The cooling system could be a two-phase cooling system such as an oscillating heat pipe 101 or any other suitable two-phase cooling system. The cooling system could be used for cooling electronic components and devices such a LiDAR devices.

The system is suitable for enabling a small amount of working fluid to be added to the oscillating heat pipe 101. The small amount of fluid could be less than 1g. Fig. 7A shows a system that is used for a first stage of the process of charging an oscillating heat pipe 101 and Fig. 7B shows a system that is used for second stage of the process of charging an oscillating heat pipe 101. In the first stage a cylinder 703 is charged from a pressurized container 701. In the second stage the oscillating heat pipe 101 is charged from the cylinder 703. The oscillating heat pipe 101 can be an oscillating heat pipe 101 as shown in Figs. 2 and 3 or any other suitable type of cooling system. In examples where the cooling system comprises an oscillating heat pipe, the examples of the disclosure can be used to partially fill the oscillating heat pipe as needed.

At the start of the process the working fluid is comprised within the pressurized container 701. The pressurized container 701 can be a bottle or any other suitable type of container. The pressurized container 701 can be a portable container. The cylinder 703 is connected to a plurality of valves. In the examples of Fig. 7A the cylinder 703 is connected to a first valve 705 and a second valve 707. The first valve 705 and second valve 707 are provided on either side of the cylinder 703 so that the cylinder 703 is provided between the valves 705, 707. The valves 705, 707 could be Schrader valves or any other suitable type of valve. The same type of valve 705, 707 could be used for the first valve 705 and the second valve 707.

The pressurized container 701 is also connected to the first valve 705. In the example of Fig. 7A the pressurized container 701 is connected to the first valve 705 by the hose 709 and the third valve 711.

A fourth valve 713 is configured to enable the cylinder 703 to be connected to a vacuum pump. The vacuum pump is not shown in Fig. 7A. The fourth valve 713 can be a three-way valve.

To enable working fluid to be discharged from the pressurized container 701 to the cylinder 703 a vacuum is created in the cylinder 703. To create the vacuum in the cylinder the third valve 711 is closed while the other valves 703, 705 in the system are opened. A vacuum pump connected to the fourth valve 713 can be used to create the vacuum.

Once the vacuum has been created the system can be pressurized by opening and closing the third valve 711. The vacuum pump can then be disconnected and the fourth valve 713 can be closed. The system can then be filled with working fluid from the pressurized container 701. The hose 709, or other suitable parts of the system can be gradually heated to force the working fluid into the cylinder 703.

The mass of working fluid in the cylinder 703 can be determined by weighing the system, or parts of the system, before and after the filling.

Fig. 7B shows a system that can be used for the second part of the process for adding working fluid to the oscillating heat pipe 101. In this second part of the process the working fluid can be transferred from the cylinder 703 to the oscillating heat pipe 101.

In the example of Fig. 7B the oscillating heat pipe 101 is connected to the cylinder 703 via a hose 715 and a three-way valve 717. The oscillating heat pipe 101 can be connected to the three-way valve 717 via a capillary copper tube or by any other suitable means.

To enable the working fluid to be discharged from the cylinder 703 to the oscillating heat pipe 101 a vacuum is created inside the oscillating heat pipe 101. The vacuum pump connected to the fourth valve 713 can be used to create the vacuum.

The system, including the oscillating heat pipe 101 can then be pressurized before the vacuum pump is disconnected.

The valves 707, 717 between the cylinder 703 and the oscillating heat pipe 101 can then be opened to enable the working fluid to flow from the cylinder 703 to the oscillating heat pipe 101. The appropriate parts of the system, such as the hose 715, can be heated to force the working fluid into the oscillating heat pipe 101. Once the working fluid has been forced into the oscillating heat pipe 101 the valve 717 can be closed.

The mass of working fluid that has been charged into the oscillating heat pipe 101 can be determined by weighing the oscillating heat pipe 101.

## Claims

1. An oscillating heat pipe (101) comprising:
a channel (211) configured to enable flow of working fluid between at least one condenser region 103 and at least one evaporator region 105; **characterized in that** the oscillating pipe further comprises:
at least one wick structure (201) in fluidic connection with the channel (211) so as to enable working fluid to flow from the channel into the wick structure (201); and
at least one vent (209) configured to enable working fluid in an, at least partial, vapour phase to be returned from the wick structure (201) to the channel (211).

2. An oscillating heat pipe as claimed in claim 1 wherein the wick structure is located within at least one evaporator region.

3. An oscillating heat pipe as claimed in any preceding claim wherein the oscillating heat pipe comprises a plurality of U-shaped bends within the evaporator region.

4. An oscillating heat pipe as claimed in claim 3 wherein the at least one wick structure is located at, at least one of, the U-shaped bends.

5. An oscillating heat pipe as claimed in any preceding claim wherein a single wick structure is fluidically connected to a plurality of different sections of evaporator regions of the oscillating heat pipe.

6. An oscillating heat pipe as claimed in any preceding claim wherein a plurality of wick structures are connected to a plurality of different evaporator regions of the oscillating heat pipe.

7. An oscillating heat pipe as claimed in any preceding claim wherein the wick structure comprises a gating portion and an evaporator portion.

8. An apparatus comprising an oscillating heat pipe as claimed in any preceding claim and one or more heat sources wherein the oscillating heat pipe is configured to cool the one or more heat sources.

9. An apparatus as claimed in claim 8 wherein the one or more heat sources comprise laser circuitry configured to enable light detection and ranging and wherein the oscillating heat pipe is configured to cool the laser circuitry.

10. An apparatus as claimed in claim 9 wherein the laser circuitry configured for light detection and ranging is configured to provide light in at least two distinct bands of wavelengths.

11. An apparatus as claimed in any of claims 9 to 10 wherein the laser circuitry comprises at least two different reflective semiconductor optical amplifiers configured to provide light in, at least two distinct bands of wavelengths.

12. An electronic device comprising an apparatus as claimed in any of claims 8 to 11 wherein the electronic device comprises at least one of; a communication device, a camera, a vehicle, and a part of a vehicle.

## Patentansprüche

1. Oszillierendes Wärmerohr (101), das Folgendes umfasst:
einen Kanal (211), der dazu ausgelegt ist, einen Fluss eines Arbeitsfluids zwischen mindestens einer Verflüssigerregion (103) und mindestens einer Verdampferregion (105) zu ermöglichen; **dadurch gekennzeichnet, dass** das oszillierende Rohr ferner Folgendes umfasst:
mindestens eine Dochtstruktur (201) in fluidischer Verbindung mit dem Kanal (211), um es einem Arbeitsfluid zu ermöglichen, vom Kanal in die Dochtstruktur (201) zu fließen; und
mindestens eine Öffnung (209), die dazu ausgelegt ist, es einem Arbeitsfluid in einer mindestens teilweisen Dampfphase zu erlauben, von der Dochtstruktur (201) zum Kanal (211) zurückgeführt zu werden.

2. Oszillierendes Wärmerohr nach Anspruch 1, wobei sich die Dochtstruktur in mindestens einer Verdampferregion befindet.

3. Oszillierendes Wärmerohr nach einem der vorhergehenden Ansprüche, wobei das oszillierende Wärmerohr eine Vielzahl von U-förmigen Krümmungen in der Verdampferregion umfasst.

4. Oszillierendes Wärmerohr nach Anspruch 3, wobei sich die mindestens eine Dochtstruktur in mindestens einer der U-förmigen Krümmungen befindet.

5. Oszillierendes Wärmerohr nach einem der vorhergehenden Ansprüche, wobei eine einzelne Dochtstruktur mit einer Vielzahl von verschiedenen Bereichen von Verdampferregionen des oszillierenden Wärmerohrs fluidisch verbunden ist.

6. Oszillierendes Wärmerohr nach einem der vorhergehenden Ansprüche, wobei eine Vielzahl von Dochtstrukturen mit einer Vielzahl von verschiedenen Verdampferregionen des oszillierenden Wärmerohrs verbunden sind.

7. Oszillierendes Wärmerohr nach einem der vorhergehenden Ansprüche, wobei die Dochtstruktur einen Gatingabschnitt und einen Verdampferabschnitt umfasst.

8. Einrichtung, die ein oszillierendes Wärmerohr nach einem der vorhergehenden Ansprüche und eine oder mehrere Wärmequellen umfasst, wobei das oszillierende Wärmerohr dazu ausgelegt ist, die eine oder die mehreren Wärmequellen zu kühlen.

9. Einrichtung nach Anspruch 8, wobei die eine oder die mehreren Wärmequellen eine Laserschaltung umfassen, die dazu ausgelegt ist, eine Lichtdetektion und eine Entfernungsmessung zu ermöglichen, und wobei das oszillierende Wärmerohr dazu ausgelegt ist, die Laserschaltung zu kühlen.

10. Einrichtung nach Anspruch 9, wobei die Laserschaltung, die für eine Lichtdetektion und eine Entfernungsmessung ausgelegt ist, dazu ausgelegt ist, Licht in mindestens zwei eindeutigen Wellenlängenbändern bereitzustellen.

11. Einrichtung nach einem der Ansprüche 9 bis 10, wobei die Laserschaltung mindestens zwei verschiedene reflektierende optische Halbleiterverstärker umfasst, die dazu ausgelegt sind, Licht in mindestens zwei eindeutigen Wellenlängenbändern bereitzustellen.

12. Elektronische Vorrichtung, die eine Einrichtung nach einem der Ansprüche 8 bis 11 umfasst, wobei die elektronische Vorrichtung mindestens eines von Folgendem umfasst: eine Kommunikationsvorrichtung, eine Kamera, ein Fahrzeug und ein Teil eines Fahrzeugs.

## Revendications

1. Caloduc oscillant (101) comprenant :
un canal (211) configuré pour permettre l'écoulement d'un fluide de travail entre au moins une région de condensation (103) et au moins une région d'évaporation (105) ; **caractérisé en ce que** le conduit oscillant comprend en outre :
au moins une structure de mèche (201) en connexion fluidique avec le canal (211) de manière à permettre au fluide de travail de s'écouler du canal dans la structure de mèche (201) ; et
au moins un évent (209) configuré pour permettre au fluide de travail au moins partiellement en phase vapeur d'être renvoyé de la structure de mèche (201) vers le canal (211).

2. Caloduc oscillant selon la revendication 1, dans lequel la structure de mèche est située dans au moins une région d'évaporation.

3. Caloduc oscillant selon l'une des revendications précédentes, dans lequel le caloduc oscillant comprend une pluralité de coudes en forme de U dans la région d'évaporation.

4. Caloduc oscillant selon la revendication 3, dans lequel la au moins une structure de mèche est située au niveau d'au moins un des coudes en forme de U.

5. Caloduc oscillant selon l'une des revendications précédentes, dans lequel une seule structure de mèche est connectée fluidiquement à une pluralité de sections différentes de régions d'évaporation du caloduc oscillant.

6. Caloduc oscillant selon l'une des revendications précédentes, dans lequel une pluralité de structures de mèche sont connectées à une pluralité de différentes régions d'évaporation du caloduc oscillant.

7. Caloduc oscillant selon l'une des revendications précédentes, dans lequel la structure de mèche comprend une partie d'attaque et une partie d'évaporation.

8. Appareil comprenant un caloduc oscillant selon l'une des revendications précédentes et une ou plusieurs sources de chaleur, dans lequel le caloduc oscillant est configuré pour refroidir les une ou plusieurs sources de chaleur.

9. Appareil selon la revendication 8, dans lequel les une ou plusieurs sources de chaleur comprennent une circuiterie laser configurée pour permettre la détection et la télémétrie par la lumière, et dans lequel le caloduc oscillant est configuré pour refroidir la circuiterie laser.

10. Appareil selon la revendication 9, dans lequel la circuiterie laser configurée pour la détection et la télémétrie par la lumière est configurée pour fournir une lumière dans au moins deux bandes de longueurs d'onde distinctes.

11. Appareil selon l'une des revendications 9 à 10, dans lequel la circuiterie laser comprend au moins deux amplificateurs optiques à semi-conducteur réfléchissant différents configurés pour fournir de la lumière dans au moins deux bandes de longueurs d'onde distinctes.

12. Dispositif électronique comprenant un appareil selon l'une des revendications 8 à 11, dans lequel le dispositif électronique comprend au moins l'un parmi : un dispositif de communication, une caméra, un véhicule et une partie d'un véhicule.
